# DEMANDE DE BREVET EUROPEEN

(11) **EP 1 580 807 A1**
(43) Date de publication de la demande: **28.09.2005**
(21) Numéro de dépôt: 05101927.1
(22) Date de dépôt: 11.03.2005
(51) Int. Cl.: H01L 23/473

(54) **Refroidisseur pour composant électronique de puissance**

(30) Priorité: 12.03.2004 FR 0450507
(71) Demandeur: Metal Process, 77144 Montevrain (FR)
(72) Inventeur: Godet, Claude, 38330, Saint-Nazaire-les-Eymes (FR); Tantolin, Christian, 38660, Lumbin (FR)
(74) Mandataire: de Beaumont, Michel

(57) **Abrégé**

L'invention concerne un refroidisseur (10) comprenant un corps (12) réalisé en un matériau métallique bon conducteur de la chaleur et de l'électricité ayant une face destinée à supporter un composant électronique de puissance (14) constituant une source de chaleur. Le corps comporte une pluralité d'ouvertures (22) traversées axialement par des tubes (24) de circulation d'un liquide de refroidissement. Chaque tube est réalisé en un matériau bon conducteur de la chaleur et est séparé du corps par une couche annulaire d'isolation électrique constituée d'une poudre comprimée d'au moins un matériau bon isolant électrique et bon conducteur de la chaleur. La présente invention concerne également un procédé de fabrication d'un tel refroidisseur.

## Description

La présente invention concerne un refroidisseur pour un composant électronique de puissance, par exemple un thyristor, un triac, un transistor MOS de puissance ou un transistor bipolaire à grille isolée (IGBT de l'anglais "Insulated Gate Bipolar Transistor"). Plus particulièrement, la présente invention concerne un refroidisseur dans lequel un liquide de refroidissement est mis en circulation pour évacuer des calories fournies par le composant électronique de puissance.

Le refroidisseur doit assurer trois fonctions principales :
- fixation mécanique du composant à refroidir ;
- évacuation de calories fournies par le composant ; et
- isolation électrique du composant par rapport au liquide de refroidissement.

Un refroidisseur classique comprend généralement un corps parallélépipédique sur lequel est fixé le composant à refroidir, et qui est constitué d'un matériau bon conducteur de la chaleur. Pour faciliter le montage du composant sur le refroidisseur et éviter l'apparition de résistances thermiques, le matériau constituant le corps du refroidisseur est généralement également un bon conducteur électrique. Il s'agit généralement d'un métal, par exemple du cuivre ou de l'aluminium. Le corps est traversé par des ouvertures cylindriques parallèles contenant des tubes dans lesquels circule le liquide de refroidissement.

La demande française 2 729 044 déposée au nom de la société Atherm décrit un refroidisseur dans lequel chaque tube est constitué d'un isolant électrique pour isoler électriquement le liquide de refroidissement du composant électronique de puissance. Chaque tube est séparé de l'ouverture correspondante du corps du refroidisseur par un interstice rempli d'un alliage métallique pour optimiser l'échange thermique entre le composant électronique de puissance et le liquide de refroidissement.

Toutefois, il peut être difficile de trouver pour les tubes un matériau qui présente un compromis convenable entre une bonne isolation électrique et une bonne conductivité thermique. En effet, chaque tube doit avoir des parois d'une épaisseur supérieure à une épaisseur minimale pour obtenir une isolation électrique suffisante et pour avoir une tenue mécanique suffisante, notamment pour simplifier la manipulation et le montage du tube. Ceci tend à dégrader les propriétés de conductivité thermique du tube.

En outre, la fabrication d'un tel refroidisseur est relativement complexe, notamment pour assurer une bonne fixation des tubes par rapport au corps du refroidisseur.

De plus, selon la demande française 2 729 044, le refroidisseur peut comprendre, dans chaque tube, un moyen de guidage de l'écoulement du liquide de refroidissement dans le tube, appelé "turbulateur". Les turbulateurs permettent d'augmenter le coefficient de Reynolds local du liquide de refroidissement s'écoulant dans les tubes pour accroître les échanges thermiques entre le liquide de refroidissement et les tubes. Les turbulateurs sont maintenus dans les tubes associés par l'intermédiaire de vis, ce qui augmente la complexité du montage d'un tel refroidisseur.

La présente invention vise à obtenir un refroidisseur pour composant électronique de puissance comportant un corps de refroidisseur, sur lequel est monté le composant, traversé par des tubes dans lesquels circule un liquide de refroidissement, le refroidisseur permettant d'accroître les échanges thermiques entre le liquide de refroidissement et le corps du refroidisseur.

Un autre objet de l'invention consiste à améliorer l'isolation électrique du liquide de refroidissement par rapport au composant.

Un autre objet de l'invention consiste, dans le cas où les tubes de refroidissement sont équipés de turbulateurs, à faciliter le montage des turbulateurs.

Pour atteindre ces objets, la présente invention prévoit un refroidisseur comprenant un corps réalisé en un matériau métallique ayant une face destinée à supporter un composant électronique de puissance, le corps comportant une pluralité d'ouvertures traversées axialement par des tubes de circulation d'un liquide de refroidissement, chaque tube étant réalisé en un matériau bon conducteur de la chaleur et étant séparé du corps par une couche annulaire d'isolation électrique constituée d'une poudre comprimée d'au moins un matériau bon isolant électrique et bon conducteur de la chaleur.

Selon un mode de réalisation de la présente invention, chaque tube est en métal.

Selon un mode de réalisation de la présente invention, la poudre comprimée est une poudre de nitrure de bore et/ou de nitrure d'aluminium.

Selon un mode de réalisation de la présente invention, le refroidisseur comporte en outre, au moins dans un tube, un moyen de guidage destiné à accélérer l'écoulement du liquide de refroidissement en contact avec le tube est réalisé en un matériau bon conducteur de la chaleur.

Selon un mode de réalisation de la présente invention, le moyen de guidage est maintenu uniquement par contact avec le tube.

Selon un mode de réalisation de la présente invention, le moyen de guidage comprend une portion cylindrique sur le pourtour de laquelle s'étendent des cannelures séparées par des dents, les cannelures étant adaptées au passage du liquide de refroidissement, les dents étant en contact avec le tube.

La présente invention prévoit également un procédé de fabrication d'un refroidisseur, comportant les étapes suivantes :
a) prévoir un corps du refroidisseur en un matériau métallique ayant une face destinée à supporter un composant électronique de puissance, le corps étant traversé par une pluralité d'ouvertures ;
b) placer dans chaque ouverture un tube séparé de l'ouverture par un interstice annulaire ;
c) remplir chaque interstice annulaire d'une poudre d'au moins un matériau bon isolant électrique et bon conducteur de la chaleur ; et
d) comprimer la poudre dans chaque interstice.

Selon un mode de réalisation de la présente invention, l'étape b) comprend, pour chaque ouverture, la mise en place d'un manchon tubulaire traversé par un orifice à une extrémité de l'ouverture, le tube étant maintenu dans l'orifice du manchon à distance du corps, la poudre étant alors introduite, à l'étape c), dans l'interstice annulaire au niveau de l'extrémité axiale de l'ouverture opposée au manchon.

Selon un mode de réalisation de la présente invention, l'étape d) est suivie par la mise en place d'un manchon tubulaire supplémentaire au niveau de l'extrémité de l'ouverture par laquelle la poudre a été introduite.

Selon un mode de réalisation de la présente invention, le procédé comprend avant l'étape c), la mise en place d'un moyen de guidage dans au moins un tube, la compression de la poudre étant effectuée de manière à déformer le tube pour qu'il vienne en contact avec le moyen de guidage et le maintienne en place.

Ces objets, caractéristiques et avantages, ainsi que d'autres de la présente invention seront exposés en détail dans la description suivante d'un exemple de réalisation particulier faite à titre non-limitatif en relation avec les figures jointes parmi lesquelles :
la figure 1 est une vue en perspective schématique d'un exemple de réalisation d'un refroidisseur selon l'invention sur lequel est monté un composant électronique de puissance à refroidir ;
la figure 2 est une vue de dessus du refroidisseur de la figure 1 ;
la figure 3 est une coupe de la figure 2 selon la ligne III-III ;
la figure 4 est un agrandissement d'une partie de la figure 3 ;
la figure 5 est une section de la figure 4 selon la ligne V-V ; et
la figure 6 est une vue en perspective schématique d'un exemple de réalisation de turbulateur.

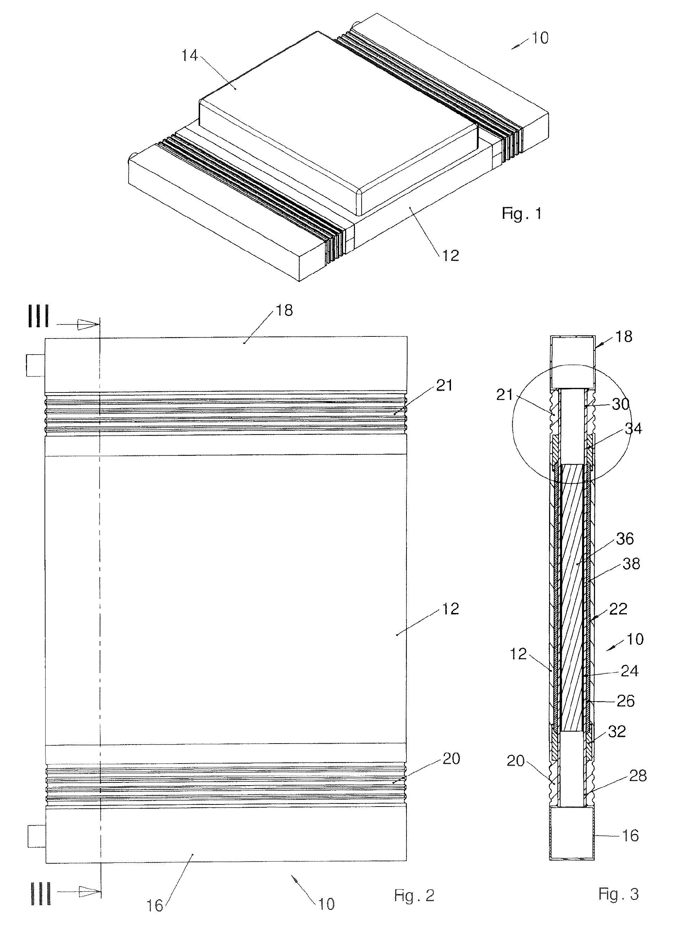

La figure 1 représente schématiquement un exemple de réalisation d'un refroidisseur 10 selon l'invention comportant un corps parallélépipédique 12, constitué d'un matériau qui est à la fois un bon conducteur thermique et un bon conducteur électrique, par exemple du cuivre ou de l'aluminium, sur lequel est fixé un composant électronique de puissance 14 à refroidir.

La figure 2 est une vue de dessus du refroidisseur 10. Le corps 12 est traversé par des ouvertures, non visibles en figure 2, parallèles et de section circulaire, dans lesquelles circule un liquide de refroidissement, par exemple de l'eau glycolée. La mise en circulation du liquide est assurée par un collecteur d'admission 16 et un collecteur d'échappement 18. Des liaisons isolantes 20, 21, par exemple en silicone, sont prévues entre le corps 12 et les collecteurs 16, 18.

La figure 3 est une coupe de la figure 2 selon la ligne III-III réalisée au niveau d'une ouverture 22 traversant le corps 12 du refroidisseur. La structure décrite par la suite est identique pour chaque ouverture 22 du corps 12 du refroidisseur. L'ouverture 22 contient un tube 24 métallique, par exemple en cuivre ou en aluminium, correspondant à un bon conducteur thermique, qui est séparé de l'ouverture 22 par un interstice 26. A titre d'exemple, le tube 24 a une épaisseur radiale de l'ordre de 0,5 mm et l'interstice a une épaisseur radiale de l'ordre de 2 mm. L'interstice 26 contient une poudre comprimée constituée d'un matériau qui correspond à un bon isolant électrique et à un bon conducteur thermique. La poudre peut également être constituée d'un mélange de matériaux qui correspondent chacun à un bon isolant électrique et à un bon conducteur thermique. Il s'agit par exemple de nitrure de bore ou de nitrure d'aluminium. Le tube 24 comprend une première portion d'extrémité 28 qui se prolonge hors de l'ouverture 22 et qui est fixée au collecteur d'admission 16 et une seconde portion d'extrémité 30 qui se prolonge hors de l'ouverture 22 et qui est fixée au collecteur d'échappement 18. La liaison entre chaque portion d'extrémité 28, 30 du tube 24 et les collecteurs d'admission 16 et d'échappement 18 peut être réalisée par tout procédé connu, par exemple par soudage ou par brasage. De chaque côté du corps 12 du refroidisseur, une partie des portions d'extrémité 28, 30 du tube 24 en saillie par rapport au corps 12, est entourée par un manchon isolant 32, 34, par exemple en fibre de verre, pénétrant légèrement dans l'ouverture 24 du corps 12, entre le tube 24 et le corps 12, pour empêcher tout contact entre le tube 24 et le corps 12. Les liaisons isolantes 20, 21 entourent les portions d'extrémité 28, 30 du tube 24 et une partie des manchons isolants 34 entre le corps 12 et les collecteurs 16, 18 pour empêcher la formation d'arcs électriques entre le corps 12 et le tube 24. Un turbulateur 36, ayant la forme d'un profilé plein, est disposé dans le tube 24. Le turbulateur 36 délimite avec le tube des passages 38, s'étendant sur toute la longueur de l'ouverture 22, par lesquels s'écoule le liquide de refroidissement.

Les collecteurs d'admission 16 et d'échappement 18 comportent des ouvertures internes, non représentées, agencées pour obtenir un type particulier d'écoulement du liquide de refroidissement dans le corps 12 du refroidisseur. Selon un premier exemple, le collecteur d'admission 16 et le collecteur d'échappement 18 peuvent comprendre chacun une ouverture dans laquelle débouchent tous les tubes 24 de façon que le liquide de refroidissement s'écoule simultanément dans chaque tube 24 depuis le collecteur d'admission 16 vers le collecteur d'échappement 18. Selon un second exemple, le collecteur d'admission 16 et le collecteur d'échappement 18 comprennent des orifices reliant les tubes 24 par paire de façon que le liquide de refroidissement s'écoule en zigzag successivement depuis un tube vers un tube adjacent.

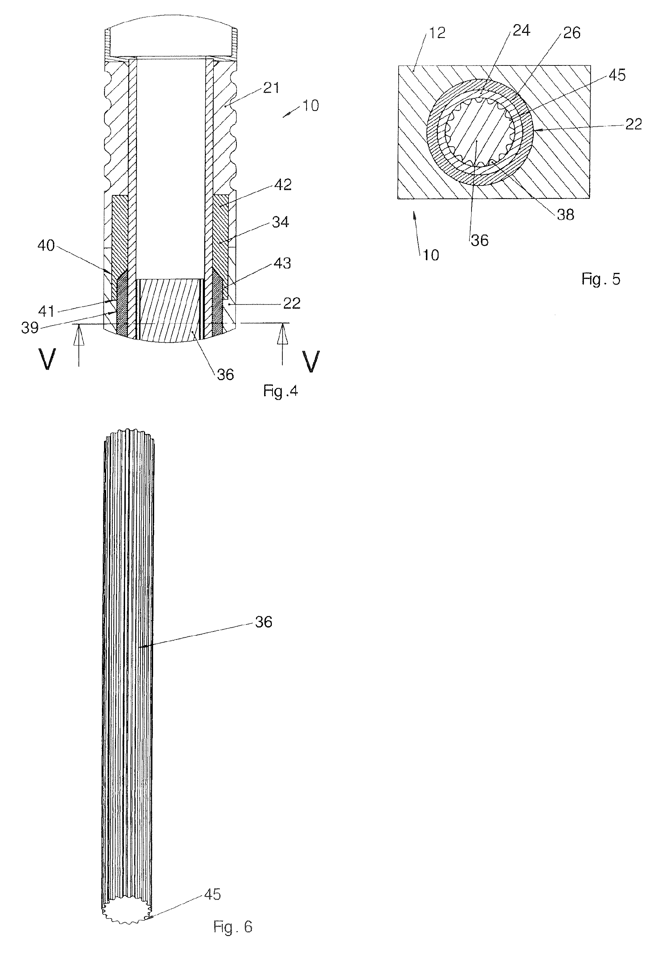

La figure 4 est une vue agrandie d'une partie de la figure 3 au niveau d'une extrémité du tube 24. L'ouverture 22 se divise en une ouverture principale 39 de section circulaire constante qui se prolonge à chaque extrémité par une ouverture d'extrémité 40, de plus grand diamètre, reliée à l'ouverture principale 39 par un épaulement 41. Chaque manchon isolant d'extrémité 34 comprend une portion principale tubulaire 42 dont le diamètre extérieur correspond au diamètre intérieur de l'ouverture d'extrémité 40 et dont le diamètre intérieur correspond au diamètre extérieur du tube 24. La portion principale tubulaire 42 se prolonge par une portion tubulaire secondaire 43 dont le diamètre extérieur correspond au diamètre intérieur de l'ouverture d'extrémité 40 et dont le diamètre intérieur correspond sensiblement au diamètre intérieur de l'ouverture principale 39. La portion tubulaire secondaire 43 vient en butée contre l'épaulement 41, une partie de la portion tubulaire principale 42 s'étendant alors hors de l'ouverture 22.

La figure 5 est une section de la figure 4 selon la ligne V-V et la figure 6 est une vue en perspective du turbulateur 36. Le turbulateur 36 a la forme d'un arbre cylindrique d'axe D sur le pourtour duquel sont réparties des dents 45 qui s'étendent parallèlement à l'axe D sur toute la longueur du turbulateur 36. Les passages 38 délimités entre le turbulateur 36 et le tube 24 correspondent aux sillons entre deux dents 45 adjacentes. Le turbulateur 36 permet localement d'augmenter la vitesse du liquide de refroidissement et donc d'augmenter le coefficient de Reynolds local du liquide de refroidissement qui est représentatif des échanges thermiques entre le liquide de refroidissement et le tube 24 et entre le liquide de refroidissement et le turbulateur 36.

Le turbulateur 36 est en contact avec le tube 24 au niveau des extrémités des dents 45, ce qui entraîne des échanges thermiques entre le turbulateur 36 et le tube 24. Le turbulateur 36 est alors avantageusement constitué d'un matériau bon conducteur de la chaleur et participe à l'évacuation des calories fournies par le composant à refroidir. A titre d'exemple, le turbulateur 36 peut être constitué du même matériau que le tube 24. La section représentée en figure 5 est particulièrement avantageuse puisqu'elle permet d'obtenir une surface d'échange thermique importante entre le turbulateur 36 et le tube 24.

Plus généralement, la section du turbulateur 36 est définie en fonction du débit et de la perte de charge que l'on souhaite obtenir pour le tube 24 tout en cherchant à rendre maximum les échanges thermiques entre le turbulateur 36 et le tube 24. Dans le cas où il est nécessaire de faire passer un débit relativement important dans le tube 24, on peut prévoir un turbulateur 36 creux, le liquide de refroidissement pouvant alors s'écouler dans le turbulateur 36 et autour de celui-ci.

En outre, le turbulateur 36 peut ne pas avoir une section constante. A titre d'exemple, les dents 45 peuvent avoir une forme hélicoïdale enroulée autour de l'axe D.

Un exemple de procédé de fabrication du refroidisseur 10 selon l'invention comprend les étapes suivantes :
réalisation des ouvertures 22 dans le corps 12 du refroidisseur ;
mise en place des manchons isolants 32 au niveau des ouvertures d'extrémité 40 des ouvertures 22 situées d'un même côté du corps 12 ;
mise en place des tubes 24 dans les ouvertures 22 en insérant une extrémité de chaque tube 24 dans le manchon isolant 32, 34 correspondant, ce qui centre automatiquement le tube 24 par rapport à l'ouverture 22 et définit l'interstice 26 ;
mise en place dans chaque tube 24 d'un turbulateur 36. Le diamètre du tube 24 est alors légèrement supérieur au diamètre maximum du turbulateur 36 de sorte que le turbulateur 36 n'est pas en contact avec le tube 24, ou très légèrement en contact avec le tube 24. Ceci facilite l'insertion du turbulateur 36 dans le tube 24 mais requiert l'utilisation d'un système de maintien temporaire du turbulateur 36 ;
pour chaque ouverture 22, remplissage de l'interstice 26 par une poudre, par exemple du nitrure de bore, par l'extrémité de l'ouverture 22 opposée au manchon isolant 32, 34 mis en place précédemment ;
compression de la poudre par un piston de façon à obtenir une structure compacte présentant les propriétés de conductivité thermique et d'isolement électrique recherchées. La compression entraîne une légère déformation du tube 24 qui vient alors en contact avec le turbulateur 36 ; et
mise en place des manchons isolants 32, 34 aux extrémités des ouvertures 22 utilisées pour l'introduction de la poudre.

Les collecteurs d'admission 16 et d'échappement 18 sont alors fixés aux extrémités des tubes 24 et les liaisons isolantes 20, 21 sont mises en place.

La présente invention présente de nombreux avantages.

Premièrement, le critère de conductivité thermique est le critère principal à prendre en compte lors du choix du matériau constituant les tubes 24. Le critère d'isolation électrique n'est pas alors à prendre en compte. Ceci permet d'utiliser des tubes 24 métalliques qui conservent des propriétés de conductivité thermique remarquables même pour des épaisseurs importantes. L'épaisseur radiale des tubes n'est alors plus une contrainte et peut être déterminée seulement en fonction de la tenue mécanique que doit avoir le tube, notamment pour permettre sa fixation aux collecteurs. Le compromis entre une bonne isolation électrique et une bonne conductivité thermique concerne la poudre comprimée disposée entre les tubes 24 et le corps 12 du refroidisseur. Toutefois, comme il s'agit d'une poudre comprimée, il n'y a pas de contrainte de tenue mécanique particulière comme dans le cas d'un refroidisseur classique dans lequel le tube assure lui-même l'isolation électrique. L'épaisseur radiale de l'interstice contenant la poudre comprimée peut correspondre à l'épaisseur minimale assurant une isolation électrique convenable. Ceci permet de dégrader le moins possible la conductivité thermique de la couche d'isolation électrique formée par la poudre comprimée. En particulier, à performances d'isolation électrique équivalentes, l'épaisseur radiale de l'interstice contenant la poudre comprimée d'un matériau déterminé est inférieure à l'épaisseur d'un tube de passage du liquide de refroidissement réalisé à partir du même matériau isolant électrique mis en oeuvre dans un refroidisseur classique.

Deuxièmement, lorsque des turbulateurs 36 sont utilisés, ceux-ci sont en contact direct avec les tubes 24 associés. Chaque turbulateur 36 peut alors avantageusement être constitué d'un matériau bon conducteur thermique de façon à participer à l'échange thermique entre le liquide de refroidissement et le corps 12 du refroidisseur. En particulier, les turbulateurs 36 peuvent être métalliques.

Troisièmement, lorsque des turbulateurs 36 sont utilisés, ceux-ci sont maintenus par les forces de contact entre les turbulateurs et les tubes associés, de telles forces de contact étant créées lors de la compression de la poudre. Il n'est donc pas nécessaire de prévoir un système de maintien supplémentaire des turbulateurs, ce qui simplifie la structure du refroidisseur selon l'invention.

Bien entendu, la présente invention est susceptible de diverses variantes et modifications qui apparaîtront à l'homme de l'art. En particulier, les exemples d'épaisseurs mentionnées pour les tubes et les interstices sont donnés à titre d'exemple et sont à adapter par l'homme du métier selon l'application envisagée.

## Revendications

1. Refroidisseur (10) comprenant un corps (12) réalisé en un matériau métallique ayant une face destinée à supporter un composant électronique de puissance (14), le corps comportant une pluralité d'ouvertures (22) traversées axialement par des tubes (24) de circulation d'un liquide de refroidissement, chaque tube étant réalisé en un matériau bon conducteur de la chaleur et étant séparé du corps par une couche annulaire d'isolation électrique constituée d'une poudre comprimée d'au moins un matériau bon isolant électrique et bon conducteur de la chaleur.

2. Refroidisseur selon la revendication 1, dans lequel chaque tube (24) est en métal.

3. Refroidisseur selon la revendication 1, dans lequel ladite poudre comprimée est une poudre de nitrure de bore et/ou de nitrure d'aluminium.

4. Refroidisseur selon la revendication 1, comportant en outre, au moins dans un tube (24), un moyen de guidage (36) destiné à accélérer l'écoulement du liquide de refroidissement en contact avec le tube et réalisé en un matériau bon conducteur de la chaleur.

5. Refroidisseur selon la revendication 4, dans lequel le moyen de guidage (36) est maintenu uniquement par contact avec le tube (24).

6. Refroidisseur selon la revendication 4, dans lequel le moyen de guidage (36) comprend une portion cylindrique sur le pourtour de laquelle s'étendent des cannelures séparées par des dents (45), les cannelures étant adaptées au passage du liquide de refroidissement, les dents étant en contact avec le tube.

7. Procédé de fabrication d'un refroidisseur (10), comportant les étapes suivantes :
a) prévoir un corps (12) du refroidisseur en un matériau métallique ayant une face destinée à supporter un composant électronique de puissance (14), le corps étant traversé par une pluralité d'ouvertures (22) ;
b) placer dans chaque ouverture un tube (24) séparé de l'ouverture par un interstice annulaire (26) ;
c) remplir chaque interstice annulaire d'une poudre d'au moins un matériau bon isolant électrique et bon conducteur de la chaleur ; et
d) comprimer la poudre dans chaque interstice.

8. Procédé selon la revendication 7, dans lequel l'étape b) comprend, pour chaque ouverture (24), la mise en place d'un manchon tubulaire (32, 34) traversé par un orifice à une extrémité de l'ouverture (12), le tube étant maintenu dans l'orifice du manchon à distance du corps, la poudre étant alors introduite, à l'étape c), dans l'interstice annulaire (26) au niveau de l'extrémité axiale de l'ouverture opposée au manchon.

9. Procédé selon la revendication 8, dans lequel l'étape d) est suivie par la mise en place d'un manchon tubulaire (32, 34) supplémentaire au niveau de l'extrémité de l'ouverture (24) par laquelle la poudre a été introduite.

10. Procédé selon la revendication 7, comprenant, avant l'étape c), la mise en place d'un moyen de guidage (36) dans au moins un tube (24), la compression de la poudre étant effectuée de manière à déformer le tube pour qu'il vienne en contact avec le moyen de guidage et le maintienne en place.
